# FASCICULE DE BREVET EUROPEEN

(11) **EP 0 821 725 B1**
(45) Date de publication et mention de la délivrance du brevet: **01.03.2000**
(21) Numéro de dépôt: 96913600.1
(22) Date de dépôt: 17.04.1996
(51) Int. Cl.: C11D 7/50, C23G 5/024

(54) **COMPOSITION DE NETTOYAGE A FROID A BASE D'ALCANES OU DE CYCLOALCANES ET D'UN COMPOSE ORGANIQUE COMPRENANT UNE FONCTION CETONE**
KALTREINIGER AUF BASIS VON ALKANEN ODER CYCLOALKANEN UND EINER ORGANISCHEN VERBINDUNG MIT EINER KETOFUNKTION
COLD CLEANING COMPOSITION BASED ON ALKANES OR CYCLOALKANES AND AN ORGANIC COMPOUND COMPRISING A KETONE GROUP

(30) Priorité: 20.04.1995 FR 9504726
(43) Date de publication de la demande: 04.02.1998
(73) Titulaire: ELF ATOCHEM S.A., 92800 Puteaux, Hauts-de-Seine (FR)
(72) Inventeur: MICHAUD, Pascal, F-95210 Saint-Gratien (FR); MARTIN, Jean-Jacques, F-92270 Bois-Colombes (FR)
(86) Numéro de dépôt international: FR9600583
(87) Numéro de publication internationale: WO9633261

(56) Documents cités:
- EP-A- 0 412 475
- EP-A- 0 544 035
- WO-A-91/06690
- WO-A-93/13246
- WO-A-94/03579
- WO-A-94/13746
- US-A- 5 145 523
- US-A- 5 207 838
- DATABASE WPI Section Ch, Week 9506 Derwent Publications Ltd., London, GB; Class E19, AN 95-041580 XP002010609 & JP,A,06 322 393 ( TOYOTA JIDOSHA KK) , 22 Novembre 1994
- DATABASE WPI Section Ch, Week 9117 Derwent Publications Ltd., London, GB; Class E15, AN 91-122409 XP002010610 & JP,A,03 062 896 ( KAO CORP) , 18 Mars 1991
- DATABASE WPI Section Ch, Week 9132 Derwent Publications Ltd., London, GB; Class E19, AN 91-235002 XP002010611 & JP,A,03 153 799 ( TOKYO THREE BOND KK) , 1 Juillet 1991
- DATABASE WPI Section Ch, Week 9412 Derwent Publications Ltd., London, GB; Class E17, AN 94-098086 XP002010612 & JP,A,06 049 493 ( NIPPON BIRDS KK) , 22 Février 1994

## Description

La présente invention concerne une composition de nettoyage à froid de surfaces solides en milieu non aqueux à base d'un mélange d'alcanes ou de cycloalcanes et d'au moins un composé organique comprenant au moins une fonction cétone.

Cette composition est utilisable notamment pour des applications de dégraissage de surfaces solides telles que les pièces métalliques, le ciment, les céramiques, le verre, les matières synthétiques ayant été souillées par des huiles ou des graisses d'usinage et/ou de leur protection temporaire.

Cette composition est également utilisable pour le défluxage des circuits imprimés. Cette opération de défluxage consiste à éliminer le flux de soudure.

Jusqu'à présent, on utilisait pour ces diverses opérations des solvants hydrocarbonés et principalement des solvants chlorés tels que notamment le 1,1,1-trichloroéthane connu dans le métier sous la désignation T 111, ainsi que des chlorofluoroalcanes tels que le 1,1,2-trichloro-1,2,2-trifluoréthane connu dans le métier sous la désignation F 113.

Cependant, ces composés chlorés et fluorochlorés sont suspectés être responsables de la diminution de la couche d'ozone stratosphérique qui assure une protection contre certaines radiations.

Suite au Protocole de Montréal qui résulte de récentes discussions internationales sur l'environnement, ces composés chlorés ou fluorochlorés devront à brève échéance être remplacés par des substituts ayant peu ou pas d'effet destructeur vis à vis d'ozone stratosphérique.

La demande de brevet Anglaise GB 2175004 propose une composition de nettoyage pour éliminer les graisses des surfaces métalliques ou plastiques comprenant de 85 à 97 parties en poids d'hydrocarbures non-aromatiques contenant des composés aliphatiques et/ou cycloaliphatiques et de 3 à 15 parties en poids de composés aromatiques contenant au moins un groupe alkyle ayant de 8 à 18 atomes de carbone.

Cependant, cette composition présente l'inconvénient de contenir des quantités non négligeables de composés aromatiques.

A cause notamment de leur caractère plus ou moins irritant l'utilisation de tels composés dans des applications de dégraissage à froid se voit être de plus en plus limitée voir interdite.

On a maintenant trouvé une composition de nettoyage à froid, en milieu non aqueux, de surfaces solides, constituée par au moins un mélange d'alcanes ou un mélange de cycloalcanes et par au moins un composé organique comprenant au moins une fonction cétone, caractérisée par le fait que le mélange d'alcanes ou le mélange de cycloalcanes et le composé organique comprenant au moins une fonction cétone ont un point d'éclair supérieur ou égal à 40° C et inférieur à 55° C, et que la composition présente un point d'éclair supérieur ou égale à 40° C et inférieur à 55° C, de préférence compris entre 40° C et 50° C, mesuré selon la norme ASTM D 56-70.

A titre d'exemple de mélange d'alcanes utilisable selon la présente invention, on peut citer les coupes pétrolières ayant un nombre de carbone allant de 8 à 12 et de préférence allant de 9 à 11.

Parmi ces coupes pétrolières, l'invention concerne, tout particulièrement celles qui ont un point d'éclair supérieur ou égal à 40° C et de préférence inférieur à 55° C et qui présentent un intervale de distillation allant de 150° C à 195° C et, de préférence allant de 155° C à 185° C.

Parmi ces coupes pétrolières on préfère utiliser celles qui ne contiennent quasiment pas de composés aromatiques.

A titre d'illustration de telles coupes pétrolières, on peut citer les solvants isoparaffiniques vendus par la Société TOTAL sous les dénominations ISANE IP 155 (point d'éclair de 41° C) et ISANE IP 165 (point d'éclair de 48° C), la coupe pétrolière ISOPAR G commercialisée par la Société EXXON Chemical (point d'éclair 42° C).

A titre d'exemple de telle paraffine on peut citer la paraffine n-C₁₀ commercialisée par la Société CEPSA.

Par mélange de cycloalcanes on désigne présentement un mélange d'hydrocarbures saturés mono-ou polycycliques, éventuellement substitués par un ou plusieurs restes alkyle de formule générale CnH₂(n+1-a)(I) dans laquelle n est un nombre entier allant de 5 à 26 et a représente le nombre de cycles.

De préférence, on utilisera selon la présente invention des mélanges de cycloalcanes de formule (I) dans laquelle n est compris entre 5 et 12 et, de préférence, compris entre 7 et 10 et a = 1 ou 2 et de préférence a = 1 (composés monocycliques).

A titre d'illustration de tels mélanges de cycloalcanes utilisables selon la présente invention, on peut citer les mélanges d'(alkyl)cycloalcanes obtenus par hydrogénation catalytique de coupes pétrolières constituées de composés aromatiques tels que notamment, les alkylbenzènes et les divinylbenzènes et d'oléfines cycliques.

Les mélanges d'(alkyl)cycloalcanes ainsi obtenus sont essentiellement constitués d'hydrocarbures saturés cycliques pouvant avoir un ou plusieurs restes alkyle ayant de 1 à 4 atomes de carbone.

A titre d'illustration de tels mélanges, on peut citer les diethylcyclohexanes (mélange des isomères 1,2 ; 1,3 et 1,4, cis et trans) les mélanges contenant deux ou plusieurs des composés ci-après : les méthyléthylcyclohexanes, les méthylpropylcyclohexanes, les éthylpropylcyclohexanes, les dipropyl-cyclohexanes, les méthylbutylcyclohexanes, les éthylbutylcyclohexanes.

Parmi tous ces mélanges, on préfère utiliser ceux qui ont un point d'éclair supérieur ou égal à 40° C et inférieur à 55° C et qui présentent un intervalle de distillation allant de 150° C à 185° C.

Selon la présente invention, on peut également utiliser comme mélange de cycloalcanes des coupes pétrolières dites coupes naphtèniques ayant un point d'éclair supérieur ou égale à 40° C et inférieur à 55° C et présentant un intervalle de distillation allant de 150° C à 190° C.

Ces coupes naphténiques sont essentiellement constituées par des composés de formule (I) dans laquelle a = 1 et n est généralement compris entre 5 et 12. A titre d'illustration de tels composés, on peut citer les diethylcyclopentanes, les mono, di, et triethylcyclohexanes, les éthyldimethylcyclohexanes, le cyclooctane.

A titre d'exemple de telles coupes naphtèniques, on peut citer les solvants naphténiques vendus par EXXON CHEMICAL sous la dénomination NAPPAR 10.

Selon la présente invention, les composés organiques comprenant une ou plusieurs fonctions cétone présentent de préférence un point d'éclair supérieur ou égal à 40° C et, inférieur à 55° C.

A titre d'illustration de tels composés, on peut citer l'éthylamylcétone, l'éthylbutylcétone, la di-n-propylcétone, la diisobutylcétone, la cyclohexanone, la 2-méthylcyclohexanone, la 3-méthylcyclohexanone, la 4-méthylcyclohexanone.

La composition selon la présente invention comprend des proportions pondérales du mélange d'alcanes ou du mélange de cycloalcanes allant de 70 % à 99 % et, de préférence allant de 85 % à 95 % et des proportions pondérales du composé organique comprenant au moins une fonction cétone allant de 30 % à 1 % et, de préférence, allant de 15 % à 5 %.

La composition selon la présente invention est utilisable dans des applications de dégraissage à froid en milieu non aqueux, de surfaces solides telles que les pièces métalliques, le ciment, le verre, les matières synthétiques ayant été souillées par des huiles ou des graisses utilisées lors des opérations d'usinage et/ou de leur protection temporaire.

Tout particulièrement, la composition est utilisable dans des applications dites "non closes" telles que nettoyage au pinceau, au chiffon ou en pulvérisation.

La composition peut être stabilisée.

Comme stabilisants, on peut utiliser des dérivés nitrés tel que le nitrométhane, le nitroéthane, le nitropropane, le nitrotoluène ; des éthers ou des acétals tels que le diméthoxyméthane, le 1,3-dioxolane, le diméthoxyéthane; des amines telles que la triéthylamine, la dipropylamine, la diméthylamine ; des dérivés du phosphore tel que le triisodécylphoshite, le triisooctylphosphite.

La composition peut également contenir un ou plusieurs masquants d'odeur.

A titre d'exemple de tels produits, on peut citer la vanilline et ses dérives, les essences de pin, le limonène et ses dérivés.

Ces composés sont utilisés en très faibles quantités, généralement comprises entre 0,01 et 0,1 partie en poids pour 100 parties en poids de la composition.

La composition selon l'invention présente l'avantage d'être facilement éliminée après l'opération de dégraissage.

Les exemples qui suivent illustrent l'invention.

Dans ces exemples, les points d'éclair sont déterminés selon la norme ASTM D56-70.

Les composés ci-après ont été utilisés :
◆ Coupe pétrolière (C₉-C₁₁) ISOPAR G (ci-après désignée par ISO G). Cette coupe pétrolière présente un intervalle de distillation allant de 158° C à 176°C et un point d'éclair de 42° C.
◆ Naphtènes "NAPPAR 10" (ci-après désigné par NAP10). Cette coupe de cycloalcanes présente un intervalle de distillation allant de 166° C à 188° C et un point d'éclair de 45° C.
◆ Diethylcyclohexanes (mélange d'isomères, ci-après désigné par DECH). Point d'éclair de 46° C.
◆ L'ethylamylcetone (ci-après désigné par EAK) qui a un point d'éclair de 48°C.

### Exemple 1

Une grille en inox de 40 x 30 mm est pesée après enduction avec une huile entière ou hydrosoluble fournie par CASTROL, SHELL, MOBIL ou ELF, et est dégraissée à la température ambiante (environ 20° C) par agitation manuelle dans un récipient contenant une composition constituée de 90 % en poids de la coupe pétrolière ISO G et de 10 % en poids de EAK.

La composition a un point d'éclair de 42° C selon la norme ASTM D56-70.

En 30 secondes, il ne reste plus aucune trace d'huile sur la grille.

La grille est ensuite retirée du récipient puis placée à 50 cm d'un pistolet soufflant de l'air à 25° C.

La grille est sèche après 69 secondes.

### Exemples 2 à 5

On opère comme dans l'exemple 1 avec des compositions différentes.

Les constituants et leurs proportions utilisées sont reportés dans le tableau unique ci-après.

Dans ce tableau, les pourcentages des constituants des différentes compositions sont exprimés en poids.

**TABLEAU UNIQUE**

| **Constituants de la Composition** | **Exemples** | | | |
|---|---|---|---|---|
| | **2** | **3** | **4** | **5** |
| ISO G | 95 % | | | |
| NAP 10 | | 90 % | 95 % | |
| DECH | | | | 90 % |
| EAK | 5% | 10 % | 5% | 10 % |
| Point d'éclair de la Composition (° C) | 42 | 44 | 45 | 47 |
| Vitesse de séchage (secondes) | 75 | 85 | 87 | 83 |

Les compositions des exemples 2 à 5 ont des performances de nettoyage quasiment identiques. En 30 secondes, la grille est totalement exempte d'huile.

## Revendications

1. Composition de nettoyage à froid, en milieu non aqueux, constituée par au moins un mélange d'alcanes ou un mélange de cycloalcanes et par au moins un composé organique comprenant au moins une fonction cétone, caractérisée par le fait que le mélange d'alcanes ou le mélange de cycloalcanes et le composé organique comprenant au moins une fonction cétone ont un point d'éclair supérieur ou égal à 40° C et inférieur à 55°C et que la composition présente un point d'éclair supérieur ou égal à 40° C et inférieur à 55°C, mesuré selon la norme ASTM D56-70.

2. Composition selon la revendication 1, caractérisée en ce qu'elle a un point d'éclair compris entre 40° C et 50° C.

3. Composition selon la revendication 1, caractérisée en ce que le mélange d'alcanes est une coupe pétrolière ayant un nombre de carbone allant de 8 à 12 et, de préférence, allant de 9 à 11.

4. Composition selon la revendication 3, caractérisée en ce que la coupe pétrolière présente un intervalle de distillation allant de 150° C à 195° C.

5. Composition selon la revendication 1, caractérisée en ce que le mélange de cycloalcanes est un mélange d'hydrocarbures saturés mono ou polycycliques, éventuellement substitués par un ou plusieurs restes alkyle, de formule générale CnH_{2(n + 1-a}) (I)
dans laquelle n est un nombre entier allant de 5 à 12 et a est égal à 1 ou 2.

6. Composition selon la revendication 5, caractérisée en ce que le mélange de cycloalcanes de formule (I) est un mélange d'(alkyl)cycloalcanes qui présente un intervalle de distillation allant de 150° C à 185° C.

7. Composition selon la revendication 5, caractérisée en ce que le mélange de cycloalcanes de formule (I) est une coupe naphtènique qui présente un intervalle de distillation allant de 150° C à 190° C.

8. Composition selon la revendication 1, caractérisée en ce que le composé organique comprenant au moins une fonction cétone est l'éthylamylcétone.

9. Composition selon l'une des revendications 1 à 8, caractérisée en ce qu'elle comprend des proportions pondérales du mélange d'alcanes ou du mélange de cycloalcanes allant de 70 % à 99 % et, de préférence allant de 85 % à 95 %, et des proportions pondérales du composé organique comprenant au moins une fonction cétone allant de 30 % à 1 % et, de préférence allant de 15 % à 5 %.

10. Composition selon l'une des revendications 1 à 9 caractérisée en ce qu'elle contient un masquant d'odeur.

11. Application d'une composition selon l'une des revendications 1 à 10 au nettoyage à froid, en milieu non aqueux de surfaces solides.

12. Application selon la revendication 11 au dégraissage des pièces métalliques.

## Patentansprüche

1. Zusammensetzung zur Kaltreinigung in einem nichtwäßrigen Medium, bestehend aus mindestens einem Gemisch aus Alkanen oder einem Gemisch aus Cycloalkanen und aus mindestens einer eine Keto-Gruppe enthaltenden organischen Verbindung, dadurch gekennzeichnet, daß das Gemisch aus Alkanen oder das Gemisch aus Cycloalkanen und der eine Keto-Gruppe enthaltenden organischen Verbindung einen Flammpunkt über oder gleich 40 °C und unter 55 °C hat, und daß die Zusammensetzung einen Flammpunkt über oder gleich 40 °C und unter 55 °C, gemessen nach der Norm ASTM D56-70, aufweist.

2. Zusammensetzung nach Anspruch 1, dadurch gekennzeichnet, daß ihr Flammpunkt zwischen 40 °C und 50 °C liegt.

3. Zusammensetzung nach Anspruch 1, dadurch gekennzeichnet, daß das Gemisch aus Alkanen eine Erdölfraktion mit 8 bis 12, vorzugsweise mit 9 bis 11, Kohlenstoffatomen ist.

4. Zusammensetzung nach Anspruch 3, dadurch gekennzeichnet, daß die Erdölfraktion einen Siedebereich von 150 °C bis 195 °C hat.

5. Zusammensetzung nach Anspruch 1, dadurch gekennzeichnet, daß das Gemisch aus Cycloalkanen ein Gemisch aus mono- oder polycyclischen gesättigten, gegebenenfalls durch einen oder mehrere Alkylreste substituierten Kohlenwasserstoffen der allgemeinen Formel
CₙH₂₍ₙ₊₁₋ₐ₎ (I)
ist, in der n eine ganze Zahl von 5 bis 12 und a = 1 oder 2 ist.

6. Zusammensetzung nach Anspruch 5, dadurch gekennzeichnet, daß das Gemisch aus Cycloalkanen der Formel (I) ein Gemisch aus (Alkyl)cycloalkanen ist, daß einen Siedebereich zwischen 150 °C und 185 °C aufweist.

7. Zusammensetzung nach Anspruch 5, dadurch gekennzeichnet, daß das Gemisch aus Cycloalkanen der Formel (I) eine Naphthenfraktion ist, die einen Siedebereich zwischen 150 °C und 190 °C aufweist.

8. Zusammensetzung nach Anspruch 1, dadurch gekennzeichnet, daß die mindestens eine Keto-Gruppe enthaltende organische Verbindung Ethylpentylketon ist.

9. Zusammensetzung nach einem der Ansprüche 1 bis 8, dadurch gekennzeichnet, daß sie Gewichtsanteile des Gemisches aus Alkanen oder des Gemisches aus Cycloalkanen von 70 % bis 99 %, vorzugsweise von 85 % bis 95 %, und Gewichtsanteile der mindestens eine Keto-Gruppe enthaltenden organischen Verbindung von 30 % bis 1 %, vorzugsweise von 15 % bis 5 %, aufweist.

10. Zusammensetzung nach einem der Ansprüche 1 bis 9, dadurch gekennzeichnet, daß sie ein Geruchsüberdeckungsmittel enthält.

11. Verwendung einer Zusammensetzung nach einem der Ansprüche 1 bis 10 zur Kaltreinigung von festen Oberflächen in einem nichtwäßrigen Medium.

12. Verwendung nach Anspruch 11 zur Entfettung von Metallteilen.

## Claims

1. Composition for cleaning under cold conditions, in a non-aqueous medium, consisting of at least one mixture of alkanes or a mixture of cycloalkanes and of at least one organic compound comprising at least one ketone function, characterized in that the mixture of alkanes or the mixture of cycloalkanes and the organic compound comprising at least one ketone function have a flash point above or equal to 40°C and below 55°C, and that the composition has a flash point above or equal to 40°C and below 55°C, measured according to ASTM standard D56-70.

2. Composition according to Claim 1, characterized in that it has a flash point of between 40°C and 50°C.

3. Composition according to Claim 1, characterized in that the mixture of alkanes is a petroleum fraction having a carbon number ranging from 8 to 12 and preferably ranging from 9 to 11.

4. Composition according to Claim 3, characterized in that the petroleum fraction has a distillation range of from 150°C to 195°C.

5. Composition according to Claim 1, characterized in that the mixture of cycloalkanes is a mixture of saturated mono- or polycyclic hydrocarbons, optionally substituted with one or more alkyl residues, of general formula CₙH₂₍ₙ₊₁₋ₐ₎ (I)
in which n is an integer ranging from 5 to 12
and a is equal to 1 or 2.

6. Composition according to Claim 5, characterized in that the mixture of cycloalkanes of formula (I) is a mixture of (alkyl)cycloalkanes which has a distillation range of from 150°C to 185°C.

7. Composition according to Claim 5, characterized in that the mixture of cycloalkanes of formula (I) is a naphthenic fraction which has a distillation range of from 150°C to 190°C.

8. Composition according to Claim 1, characterized in that the organic compound comprising at least one ketone function is ethyl amyl ketone.

9. Composition according to one of Claims 1 to 8, characterized in that it comprises weight proportions of the mixture of alkanes or of the mixture of cycloalkanes ranging from 70% to 99%, and preferably ranging from 85% to 95%, and weight proportions of the organic compound comprising at least one ketone function ranging from 30% to 1%, and preferably ranging from 15% to 5%.

10. Composition according to one of Claims 1 to 9, characterized in that it contains an odour masker.

11. Application of a composition according to one of Claims 1 to 10, to the cleaning under cold conditions, in non-aqueous medium, of solid surfaces.

12. Application according to Claim 11, to the degreasing of metal components.
